(19)

Europäisches
Patentamt
European
Patent Office
Office européen
des brevets

(11) **EP 2 031 381 A1**

(12) **EUROPEAN PATENT APPLICATION**

(43) Date of publication:
**04.03.2009 Bulletin 2009/10**

(51) Int Cl.:
*G01N 27/02* (2006.01)  *G01R 27/00* (2006.01)
*G06T 11/00* (2006.01)

(21) Application number: **07017080.8**

(22) Date of filing: **31.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Tomoflow Ltd.**
**Wilmslow**
**Cheshire SK9 5BB (GB)**

(72) Inventors:
• **Byars Malcolm D**
**Wilmslow, Chesire SK9 6JJ (GB)**

• **Hunt, Andrew**
**Galan, 65330 (FR)**
• **Pendleton, John D**
**Altrincham, Cheshire WA15 9QH (GB)**
• **Erhardt, Daniel**
**8902 Urdorf ZH (CH)**

(74) Representative: **Frommhold, Joachim**
**Bühler AG**
**Patentabteilung**
**9240 Uzwil (CH)**

(54) **Method and apparatus for determining moisture or density of a material**

(57)    The present invention relates to a method and apparatus for determining water content and/or density of a material. Thus, a moisture distribution pattern and a density distribution pattern within the material under examination is obtained from material specific calibration characteristics for local conductivity values and for local permittivity values of the material on the one hand and from measured conductance values G measured capacitance values C between selected pairs of probe electrodes on the other hand.

**Fig. 1**

EP 2 031 381 A1

**Description**

The present invention relates to a method and apparatus for determining water content and/or density of a material.

According to the invention, there is provided a method for determining water content and/or density of a material uses the following data acquisition and data processing means:

> ➢ two or more probe electrodes (E) positioned within or in the vicinity of said material;
> ➢ impedance measuring means (IM) connected to said probe electrodes (E), said impedance measuring means being adapted to output capacitance values C and/or conductance values G representative of a distribution of the material; and
> ➢ pattern construction means (PC) for determining a conductivity distribution pattern of the material from conductance values measured between selected pairs of said probe electrodes (E), and for determining a permittivity distribution pattern of the material from capacitance values measured between selected pairs of said probe electrodes (E).

According to the invention, the method comprises the following steps:

a1) providing a first calibration characteristic for local conductivity values g within the material as a function g = g (m,d) of both moisture content m and density (concentration) d of the material;
a2) providing a second calibration characteristic for local permittivity values p within the material as a function p = p(m,d) of both moisture content m and density (concentration) d of the material;
b1) measuring conductance values G between selected pairs of probe electrodes (E) in a sequential manner by using said impedance measuring means (IM);
b2) measuring capacitance values C between selected pairs of probe electrodes (E) in a sequential manner by using said impedance measuring means (IM);
c1) constructing a conductivity distribution pattern g(x,y,z) dependent on the material from conductance values measured between selected pairs of said probe electrodes (E) by using said pattern construction means (PC);
c2) constructing a permittivity distribution pattern p(x,y,z) dependent on the material from capacitance values measured between selected pairs of said probe electrodes (E) by using said pattern construction means (PC);
d1) determining a moisture distribution pattern m(x,y,z) from said constructed conductivity distribution pattern g(x,y,z) = g(m,d) and from said constructed permittivity distribution pattern p(x,y,z) = p(m,d); and/or
d2) determining a density distribution pattern d(x,y,z) from said constructed conductivity distribution pattern g(x,y,z) = g(m,d) and from said constructed permittivity distribution pattern p(x,y,z) = p(m,d).

Thus, a moisture distribution pattern and a density distribution pattern within the material under examination is obtained from material specific calibration characteristics for local conductivity values and for local permittivity values of the material on the one hand and from measured conductance values G measured capacitance values C between selected pairs of probe electrodes on the other hand.

Preferably, the impedance measuring means includes an electrical circuit which can be operated both in conductance measuring mode and in capacitance measuring mode. Preferably, the measuring steps b1) and b2) are carried out by applying an alternating potential (source voltage VS) to the first probe electrode of each selected pair of probe electrodes and by applying a constant reference potential (Vref) to the second probe electrode of each selected pair of probe electrodes, said alternating potential being alternately above and below said reference potential.

Preferably, the impedance measuring means (IM) includes a first operational amplifier (A1) having a first measuring capacitor (C1) connected across its first and second inputs and having its output fed back to its first input; a second operational amplifier (A2) having a second measuring capacitor (C2) connected across its first and second inputs and having its output fed back to its first input; a first electrode of said first measuring capacitor (C1) being connectable to the second probe electrode of each selected pair of probe electrodes via a first switch (S1) and a second electrode of said first measuring capacitor (C1) being connected to said reference potential; a first electrode of said second measuring capacitor (C2) being connectable to the second probe electrode of each selected pair of probe electrodes via a second switch (S2) and a second electrode of said second measuring capacitor (C2) being connected to said reference potential.

Preferably, during the conductance measuring steps b1), said first switch (S1) is in a closed state while said alternating potential (VS) is increasing, while said alternating potential (VS) is above said constant reference potential and while said alternating potential (VS) is decreasing; and said second switch (S2) is in a closed state while said alternating potential (VS) is decreasing, while said alternating potential (VS) is below said constant reference potential and while said alternating potential (VS) is increasing.

Preferably, during the capacitance measuring steps b2), said first switch (S1) is in a closed state while said alternating potential (VS) is increasing; and said second switch (S2) is in a closed state while said alternating potential (VS) is decreasing.

Preferably, the alternating potential (source voltage VS) is symmetrical with respect to said constant reference potential (Vref), and more preferably, the alternating potential is a square wave potential (VS).

Preferably, during the conductance measuring steps b1), the first switch (S1) is closed before said alternating potential undergoes a transition from its low value to its high value and is opened again after said alternating potential wave undergoes a transition back to its low value; and said second switch (S2) is closed before said alternating potential undergoes a transition from its high value to its low value and is opened again after said alternating potential undergoes a transition back to its high value.

Preferably, during said capacitance measuring steps b2), said first switch (S1) is maintained in a closed state while said alternating potential undergoes a transition from its low value to its high value; and said second switch (S2) is maintained in a closed state while said alternating potential undergoes a transition from its high value to its low value.

Preferably, a voltage produced at said fed-back output of said first operational amplifier (A1) is used as a measure for the charge injected into said first capacitor (C1); and a voltage produced at said fed-back output of said second operational amplifier (A2) is used as a measure for the charge injected into said second capacitor (C2). The operational amplifiers A1 and A2 are used for the charging and discharging period of the unknown impedance, respectively.

Preferably, the impedance measuring means is operated in a conductance measurement mode during which a switching sequence defined by the closing and opening of said first switch (S1) is in phase (0 degree phase shift) with said alternating potential (source voltage VS); and a switching sequence defined by the closing and opening of said second switch (S2) is out of phase (180 degrees phase shift) with said alternating potential (source voltage VS); and wherein the duration of the closed state of each of the first and second switches (S1, S2) is longer than the duration of the open state of each of the first and second switches (S1, S2) such that there is an overlap period when both switches (S1, S2) are simultaneously closed; and calculating the conductance G from the individual or averaged output voltage of said first and/or second operational amplifiers (A1, A2).

Preferably, the impedance measuring means is operated in a capacitance measurement mode during which a switching sequence defined by the closing and opening of said first switch (S1) is out of phase (+90 degree phase shift) with said alternating potential (source voltage VS); and a switching sequence defined by the closing and opening of said second switch (S2) is out of phase (-90 degrees phase shift) with said alternating potential (source voltage VS); and wherein the duration of the closed state of each of the first and second switches (S1, S2) is longer than the duration of the open state of each of the first and second switches (S1, S2) such that there is an overlap period when both switches (S1, S2) are simultaneously closed; and calculating the capacitance C from the individual or averaged output voltage of said first and/or second operational amplifiers (A1, A2).

Preferably, the time period TC1 of the closed state of said first switch (S1), the time period TC2 of the closed state of said second switch (S2) and the time period of the overlap period TC12 at the beginning or at the end of each time period TC1 or TC2 are related such that $0.1 < TC12 / TC1 < 0.5$ and $0.1 < TC12 / TC2 < 0.5$.

Preferably, the time period TC1 of the closed state of said first switch (S1); the time period TC2 of the closed state of said second switch (S2); the positive time period Tpos, where said alternating potential (VS) is greater than said constant reference potential (Vref); and the negative time period Tneg, where said alternating potential (VS) is less than said constant reference potential (Vref) are related such that $1.1 < TC1 / Tpos < 1.5$ and $1.1 < TC2 / Tneg < 1.5$.

Preferably, the time period Tpos and the time period Tneg are identical.

Preferably, the time period TC1 and the time period TC2 are identical.

Preferably, the constant reference potential (Vref) is the ground potential.

Preferably, the conductance measurement mode and said capacitance measurement mode are performed during a conductance measurement interval and during a capacitance measurement interval, respectively.

Preferably, the conductance measurement mode and said capacitance measurement mode are performed alternately.

Preferably, the number of counted charging cycles and counted discharging cycles is increased for smaller measured or expected values of C or G and decreased for larger measured or expected values of C or G.

According to the invention, there is also provided an apparatus for determining water content and/or density of a material, which apparatus includes the following data acquisition and data processing means: two or more probe electrodes (E) for positioning within or in the vicinity of said material; impedance measuring means (IM) connected to said probe electrodes (E), said impedance measuring means being adapted to output capacitance values C and/or conductance values G representative of a distribution of the material; and pattern construction means (PC) for determining a conductivity distribution pattern of the material from conductance values measured between selected pairs of said probe electrodes, and for determining a permittivity distribution pattern of the material from capacitance values measured between selected pairs of said probe electrodes; wherein said impedance measuring means (IM) comprises: a first operational amplifier (A1) having a first measuring capacitor (C1) connected across its first and second inputs and having its output fed back to its first input; a second operational amplifier (A2) having a second measuring capacitor (C2) connected across its first and second inputs and having its output fed back to its first input; a first electrode of said first measuring capacitor (C1) being connectable to the second probe electrode of each selected pair of probe electrodes via a first switch (S1) and a second electrode of said first measuring capacitor (C1) being connected to said reference potential; a first electrode of said second measuring capacitor (C2) being connectable to the second probe electrode of each selected pair of probe electrodes via a second switch (S2) and a second electrode of said second measuring capacitor (C2) being connected to said reference potential.

Preferably, said first and second switches are electronic switches.

The following detailed description of an example of an impedance measuring means in the form of an electrical circuit will help to better understand the present invention.

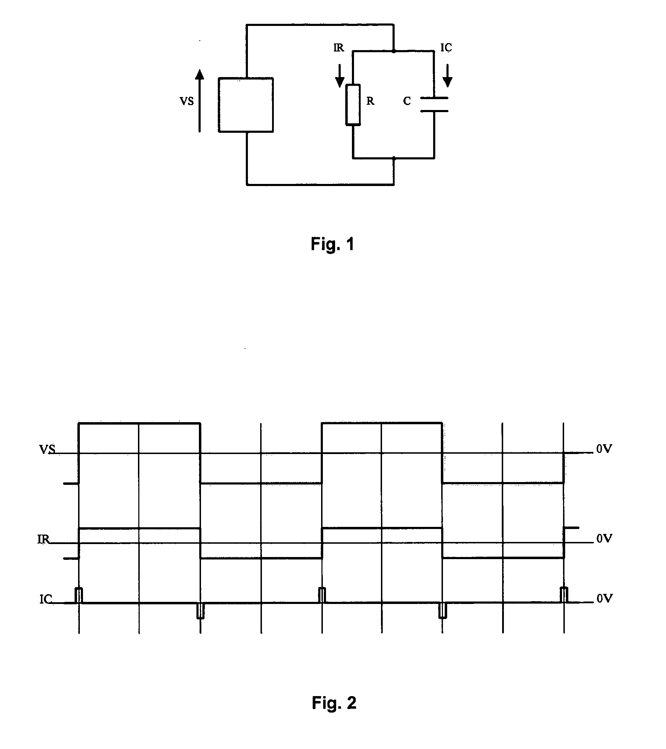

Fig. 1 shows the principle of operation of a basic capacitance/conductance measurement circuit.

The basic capacitance/conductance measurement circuit is shown in figure 1 above. Cx and Rx are the loss-free and lossy components of the impedance of a lossy unknown capacitor, which will be referred to as as Cx/Rx from now on.

In Fig. 1, VS is a square wave signal having a frequency of a few MHz. This signal is connected to one electrode of the unknown lossy capacitor (Cx/Rx) whose impedance is to be measured. The second (low potential) electrode of the capacitor is held at ground potential, so the square wave VS is connected between the two electrodes of the capacitor.

The effect of applying the signal across the capacitor is to cause current to flow through it. As there are two separate parallel current paths (through Cx and Rx), there will be two separate components of current and these are shown in Fig. 2.

Fig. 2 shows voltage and current waveforms for Cx/Rx.

The first component, IR is the current through Rx, which is shown as the waveform IR in figure 2 above. The magnitude of IR is simply given by VS/Rx and the current waveform is similar to and in phase with the applied voltage waveform VS, as shown in Fig. 2.

The second component is a pulse of current which occurs each time the capacitance Cx is charged and discharged by the applied source waveform VS. These current pulses are shown with exaggerated pulse widths as the waveforms IC in Fig. 2.

The measurement circuit operates by converting either of these current components into voltage signals which are proportional to the individual current components and hence to the magnitude of the capacitance (Cx) or the conductance (1/Rx).

These currents can be measured using the circuit described in the next section.

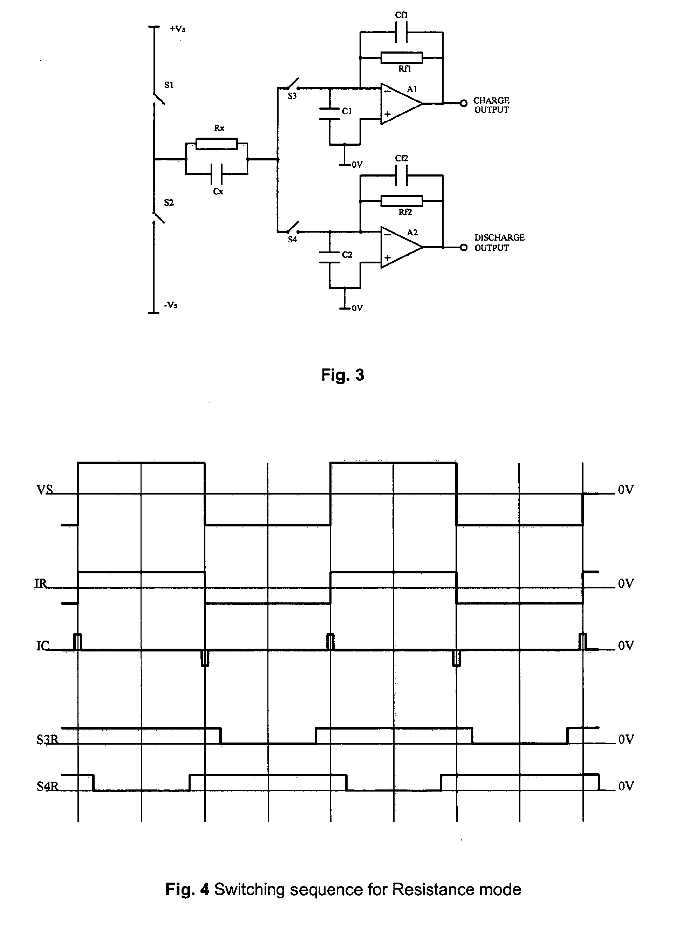

The circuit used to measure the individual current components is shown in Fig. 3.

In Fig. 3, S1 and S2 are electronic switches which generate a (typically 1 MHz) square wave SOURCE signal (shown as VS in figure 2 below), of typical amplitude ±15V. This Source signal waveform is connected to one electrode of the unknown lossy capacitor whose impedance is to be measured Cx/Rx.

The reservoir capacitors C1 and C2 are large (typically 0.1 uF) compared with Cx (typically less than 1 pF) and are never allowed to charge up to any significant voltage, as described below. As either S3 or S4 (or sometimes both switches) are closed at all times, the inverting inputs of A1 and A2 and hence the other (low potential) electrode of the unknown capacitor are held at virtual earth potentials at all times.

Consequently, when the square wave voltage SOURCE signal is applied to the high potential electrode of Cx/Rx, pulses of current flow through Cx/Rx via one or both of the capacitors C1 and C2 to earth, depending on which of the switches S3 or S4 is closed.

The general circuit operation is as follows:

The switch S3 operates so that positive current pulses through Cx/Rx are directed to the the input of amplifier A1, while S4 directs the negative curent pulses to the input of A4. The detailed operation of these switches is described in the next 2 sections.

This switching sequence causes a finite amount of charge (integrated current) to be stored in the reservoir capacitors C1 and C2 and this would normally cause voltages to develop across these capacitors. However, the amplifiers A1 and A2 prevent this from occurring by injecting an equal and opposite charge into these reservoir capacitances. What happens is that the output voltages of the amplifiers rise when any small voltage develops across the reservoir capacitances C1 and C2, and current is driven through the feedback resistors Rf1 and Rf2 until any charge injected into these reservoir capacitors via Cx/Rx has been neutralised. Cf simply determines the circuit transient measurement time constant in conjunction with Rf, but otherwise has no direct on the operation of the circuit.

Hence the output voltages from A1 and A2 are proportional to the current which flows through Cx/Rx. As the output voltages of A1 and A2 will be nominally of equal amplitude but opposite sign, these voltages can be subtracted in a difference amplifier (not shown) to give a composite output for the measurement, which is double that of the individul outputs of A1 and A2.

The detailed circuit operation in both Resistance and Capacitance measurement modes is described in the following sections.

RESISTANCE MEASUREMENT MODE

In Resistance (or Conductance) mode, the switching sequences of S3 and S4 are shown in Fig. 4 as the waveforms S3R and S4R. Note that the convention used is that when the waveforms S3R and S4R have logic high values, the corresponding electronic switch is turned ON (closed) and when they have logic LOW values, the switch is turned OFF (open).

In resistance mode, the switching sequence takes the form of a pair of overlapping quasi-square waves, one in-phase and the other 180 degrees out of phase with the SOURCE voltage waveform VS. However, there is a short period of time (the overlap period) when both switches S3 and S4 are on.

We will consider how this circuit responds to the resistive and capacitive current components in turn:

Resistive current component IR

During the switch overlap period, equal quantities of positive and negative resistive current IR are directed to both of the capacitors C1 and C2 which are effectively connected in parallel during the overlap period. As there is no net current into either C1 or C2 during this period, there is no contribution to the circuit outputs of A1 or A2 during this period. These circuits only produce outputs, which are proportional to the resistive current which flows through Rx during the non-overlapping periods of S3 and S4. Specifically, A1 responds to the positive resistive current component IR and A2 responds to the negative component of IR.

The average current which flows into either C1 or C2 during each charging or discharging cycle is given by:

$$IR = 2.(VS/Rx).(t/T) \qquad (1)$$

where VS is the peak value of the source waveform, T is the period of one source excitation cycle and t is the non-overlap ON period of either S3 or S4.

This must be balanced by an equal and opposite current generated by the output of either A1 or A2 through Rf, ie -Vo/Rf, where Vo is the output of either A1 or A2.

Hence

$$2.(VS/Rx).(t/T) = -Vo/Rf. \qquad (2)$$

giving

$$Vo = -2.(VS/Rx).(t/T).Rf \qquad (3)$$

This is the output voltage of one amplifier only. As there are two identical circuits which have complementary outputs, these can be summed in a difference amplifier. In this case, the total circuit output in resistance mode is therefore given by:

$$Vo = -4.(VS/Rx).(t/T).Rf \qquad (4)$$

Capacitive Current component IC

Now consider the response to the capacitive components of current IC in Resistance Measurement mode. Both S3 and S4 are switched on before the start of the positive capacitive charging current pulse and are switched off after the negative current pulse has finished. In this case, nominally equal amounts of capacitive current pulses (charge) will be stored in the capacitors C1 and C2 and there will be no net voltage developed across either of these capacitors due to the capacitive current pulses.

So with this switching sequence of S3 and S4, the circuit will only respond to resistive currents and will reject any capacitive currents.

Degree of switch overlap

The degree of overlap can, in principle, be adjusted to control the sensitivity of the circuit to resistive currents. If the overlap is small the sensitivity to resistive currents will be higher, whereas if it is large, the sensitivity will be lower. However, the overlap period must always ensure that both charging and discharging current pulses are captured by both of the switches S3 and S4.

CAPACITANCE MEASUREMENT MODE

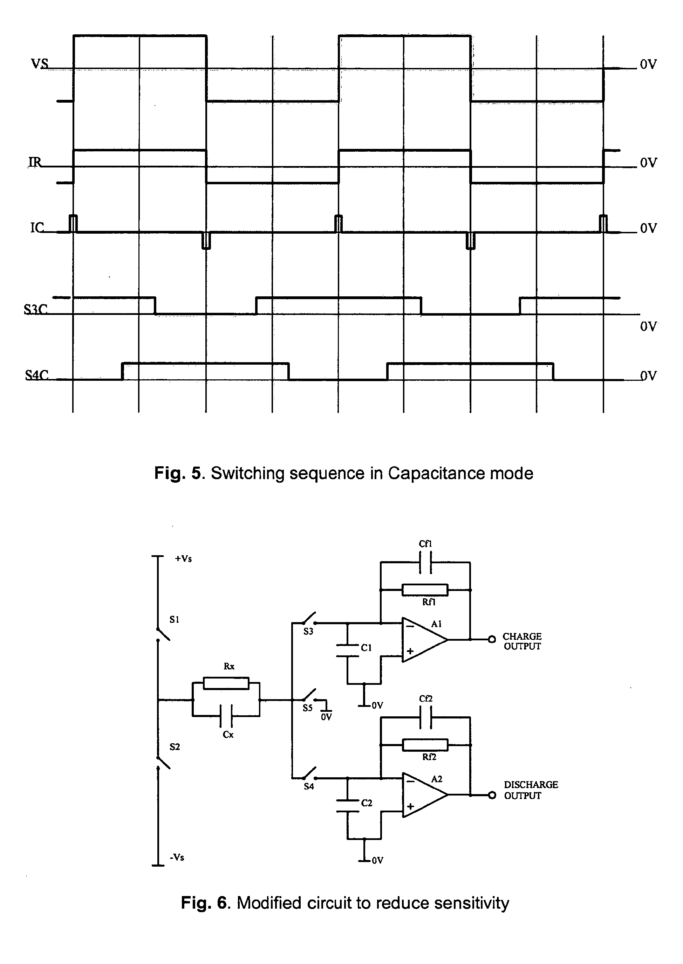

In Capacitance mode, the switching sequence of S3 and S4 is shown in Fig. 5 as the waveforms S3C and S4C. The S3/4 switching sequences are the same as in resistance mode except that they are shifted in phase by 90 degrees relative to the Source voltage waveform VS.

The response of the circuit to the capacitive and resistive components of current is as follows:

Capacitive current component IC

In capacitance mode, S3 is closed symmetrically for a period before and after the current pulse through Cx, which occurs on the positive-going transition of the SOURCE waveform VS. Similarly, S4 is closed symmetrically for a period before and after the current pulse which occurs on the negative-going transition of the SOURCE waveform. As S3 is closed and S4 is open during the positive current pulses, these positive (charging) current pulses are stored in the reservoir capacitor C1. Similarly, as S4 is closed and S3 is open during the negative current pulses, these negative (discharging) current pulses are stored in C2.

In principle, the switching sequence of S3/4 could be in the form of symmetrical square waves in quadrature with the SOURCE waveform VS. However, experience has shown that it is advantageous to overlap the switching sequence S3/4, so that for a short period, both S3 and S4 are closed, as this dramatically reduces the effects caused by charge injection in these two electronic switches.

The output voltage in capacitance mode can be calculated as follows:

As Cx and either C1 or C2 are effectively in series, the same charge is stored in each pair of capacitors Cx/C1 or Cx/C2.

When Cx is charged, the stored charge is equal to the voltage across the capacitor multiplied by the capacitance, that is:

$$Q = 2.VS.Cx \qquad\qquad (5)$$

The capacitor is charged/discharged at a rate of f, where f is the source excitation frequency.

So the average current injected into the reservoir capacitors C1 or C2 is

$$I = 2.VS.Cx.f \qquad\qquad (6)$$

This is balanced by an equal and opposite current (= -Vo/Rf) generated by the output voltages Vo of either A1 or A2.
Hence

$$-Vo/Rf = 2.VS.Cx.f \qquad\qquad (7)$$

giving

$$Vo = -2.VS.Cx.f. Rf \qquad (8)$$

As there are 2 identical circuits with complementary outputs, these outputs can be summed in a difference amplifier to produce a net output.

$$Vo = -4VS.Cx.f. Rf \qquad (9)$$

Resistive current component IR

When the circuit is in capacitance measurement mode, the amplifiers A1 and A2 will not respond to any resistive currents (waveform IR), as the timing of switches S3 and S4 ensures that equal quantities of positive and negative resistive current pulses pass into each individual reservoir capacitor C1 and C2, giving a net current into each of these capacitors of zero in each case.

Hence, in capacitance mode, the circuit rejects any resistive currents and measures only the capacitive component of impedance.

**NEED FOR CAPACITORS C1 and C2**

If the amplifiers A1 and A2 were perfect, they would maintain a virtual earth at their inputs and there would be no need for the reservoir capacitors C1 and C2. The current pulses would be immediately neutralised by the output voltages of A1 and A2. However, the finite transient response of practical amplifiers means that the reservoir capacitors are needed to reduce the incidence of transient spikes at the circuit outputs.

**MEASUREMENT SEQUENCING**

A single circuit of the type shown in Fig. 1 cannot measure capacitance and conductance simultaneously, as the switching sequence of S3 and S4 must be set to measure either capacitance or conductance. One option is therefore to interleave the measurements so that, for example, capacitance and conductance are measured sequentially.

One practical problem is that relatively low resistive impedances may overload the SOURCE waveform generator. This can be overcome by reducing the SOURCE voltage VS when the circuit is in conductance mode, which also reduces the sensitivity of the resistance measurement circuit. Further sensitivity reduction in resistance mode can be achieved by increasing the overlap in the switching sequence if required.

**SIGNIFICANCE OF DEGREE OF DETECTOR CLOCK OVERLAP**

Provided there is sufficient overlap of S3 and S4, the timing of the switching of S3 and S4 becomes relatively uncritical. This is a major improvement over the previous circuit which requires very precise control of the switch timing to be effective. The new circuit allows the measurement of either the capacitive or resistive component in a high-speed Electrical Capacitance Tomography (ECT) system.

**CHARGE INJECTION EFFECTS**

A known problem with this type of measurement circuit is that even if no capacitance Cx is connected to the inputs of the capacitance measurement circuitry, the circuit outputs will nevertheless indicate a finite (spurious) input capacitance. This output is caused by capacitive coupling between the control clock signal pins and the ouput pins of the electronic switches S3 and S4 and is known as charge injection.

The magnitude of this spurious capacitance can easily exceed that of the unknown capacitance Cx unless care is taken to minimise this effect. Experience has shown that one parameter which has a marked effect on the magnitude of the charge injection capacitance is the degree of overlap of S3 and S4. If there is no overlap, the charge injection capacitance magnitude is large and it reduces as the clock overlap increases.

Even if the clock overlap is optimised to minimise charge injection effects, there will still be some residual charge injection capacitance outputs from A1 and A2. If these outputs are caused purely by internal coupling within the electronic switches, the spurious outputs from A1 and A2 due to this effect will be of similar amplitude and polarity. They will then be cancelled in the difference amplifier which sums the A1 and A2 outputs. However, inter-track coupling on the circuit board can have a major effect on these spurious capacitance outputs and great care must be taken in the circuit board layout to minimise any coupling between the control signals to the electronic switches and the outputs of these switches.

The circuit is similar to the previous version but an additional switch S5 has been added. S5 is operated instead of S3 or S4, and connects the low potential electrode of Cx directly to ground rather than to either C1 or C2. This allows the number of charging/discharging pulses transferred to C1/2 and hence the overall measurememnt sensitivity to be reduced. Some possible timing arrangements for S3,S4 and S5 are shown in Fig. 6.

## ADJUSTMENT OF MEASUREMENT SENSITIVITY

In an ECT system, the inter-electrode capacitances to be measured Cx have relative magnitudes in a range of approximately 100 to 1. One option for reducing this measurement range is to count less charging/discharging cycles for larger values of Cx. This can be done using the modified circuit shown in Fig. 6.

The circuit is similar to the previous version but an additional switch S5 has been added. S5 is operated instead of S3 or S4, and connects the low potential electrode of Cx directly to ground rather than to either C1 or C2. This allows the number of charging/discharging pulses transferred to C1/2 and hence the overall measurememnt sensitivity to be reduced. Some possible timing arrangements for S3,S4 and S5 are shown in Fig. 6.

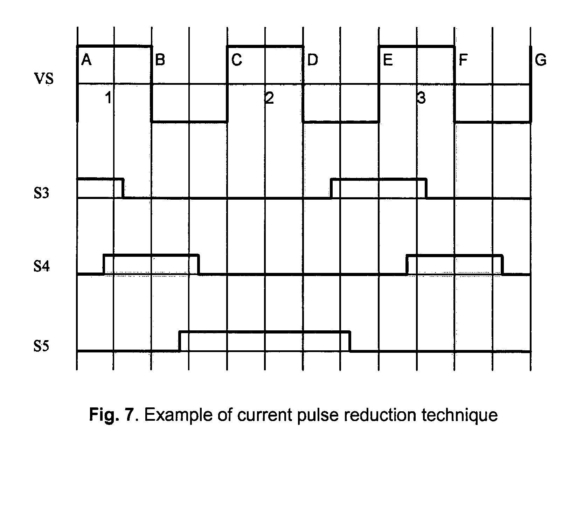

Fig. 7 shows how alternate sets of capacitive current pulses are connected to ground instead of to the capacitors C1 and C2.

The figure shows 3 complete source (VS) waveform cycles (labelled 1,2 and 3). The charging currents generated by the leading and trailing edges of cycles 1 and 3 (A,B,E,F) are directed to C1 and C2 respectively by S3 and S4 as described previously. However the charging pulses for both the leading and trailing edges of cycle 2 (C,D) are connected directly to ground by S5. The sensitivity of the circuit is therefore reduced by a factor of 2. The sensitivity can be further reduced by grounding a higher proportion of the current pulses. The sensitivity to the resistive currents can be reduced in a similar manner by adjusting the phasing of S3, S4 and S5 by 90 degrees.

## OTHER EFFECTS

Experience has shown that if the integrated circuit containing the analogue switches S3 and S4 is supplied from a symmetrical bipolar power supply, the charge injection capacitances are higher than are measured when the device is suplied from a unipolar power supply.

It is also important to prevent simultaneous conduction of S1 and S2, which would otherwise short circuit the $\pm15V$ power supplies and generate high current spikes. Experience has shown that if this is allowed to occur, errors occur in the measured capacitances in the form of assymetrical sets of measured capacitances for a symmetrical ECT sensor.

## OTHER CIRCUIT PROPERTIES

As each of the electrodes of the unknown capacitor are held at either a fixed potential which can be generated by a low impedance voltage source, or at virtual ground potential at all times, the circuit does not respond to any capacitive or resistive impedance between either electrode and ground. This property (known as stray immunity) is very important if the circuit is to be used in an ECT system, where good electrode screening is required.

## Claims

1. A method for determining water content and/or density of a material, which method uses the following data acquisition and data processing means:

   ➢ two or more probe electrodes (E) positioned within or in the vicinity of said material;
   ➢ impedance measuring means (IM) connected to said probe electrodes (E), said impedance measuring means being adapted to output capacitance values C and/or conductance values G representative of a distribution of the material; and
   ➢ pattern construction means (PC) for determining a conductivity distribution pattern of the material from conductance values measured between selected pairs of said probe electrodes (E), and for determining a permittivity distribution pattern of the material from capacitance values measured between selected pairs of said probe electrodes (E);

and which method comprises the following steps:

a1) providing a first calibration characteristic for local conductivity values g within the material as a function g = g(m,d) of both moisture content m and density (concentration) d of the material;
a2) providing a second calibration characteristic for local permittivity values p within the material as a function p = p(m,d) of both moisture content m and density (concentration) d of the material;
b1) measuring conductance values G between selected pairs of probe electrodes (E) in a sequential manner by using said impedance measuring means (IM); b2) measuring capacitance values C between selected pairs of probe electrodes (E) in a sequential manner by using said impedance measuring means (IM);
c1) constructing a conductivity distribution pattern g(x,y,z) dependent on the material from conductance values measured between selected pairs of said probe electrodes (E) by using said pattern construction means (PC);
c2) constructing a permittivity distribution pattern p(x,y,z) dependent on the material from capacitance values measured between selected pairs of said probe electrodes (E) by using said pattern construction means (PC);
d1) determining a moisture distribution pattern m(x,y,z) from said constructed conductivity distribution pattern g(x,y,z) = g(m,d) and from said constructed permittivity distribution pattern p(x,y,z) = p(m,d); and/or
d2) determining a density distribution pattern d(x,y,z) from said constructed conductivity distribution pattern g(x,y,z) = g(m,d) and from said constructed permittivity distribution pattern p(x,y,z) = p(m,d).

2. The method according to claim 1, wherein said impedance measuring means includes an electrical circuit which can be operated both in conductance measuring mode and in capacitance measuring mode, and wherein said measuring steps b1) and b2) are carried out by applying an alternating potential (source voltage VS) to the first probe electrode of each selected pair of probe electrodes and applying a constant reference potential (Vref) to the second probe electrode of each selected pair of probe electrodes, said alternating potential being alternately above and below said reference potential.

3. The method according to claim 1 or 2, wherein said impedance measuring means (IM) includes:

➢ a first operational amplifier (A1) having a first measuring capacitor (C1) connected across its first and second inputs and having its output fed back to its first input;
➢ a second operational amplifier (A2) having a second measuring capacitor (C2) connected across its first and second inputs and having its output fed back to its first input;
➢ a first electrode of said first measuring capacitor (C1) being connectable to the second probe electrode of each selected pair of probe electrodes via a first switch (S1) and a second electrode of said first measuring capacitor (C1) being connected to said reference potential;
➢ a first electrode of said second measuring capacitor (C2) being connectable to the second probe electrode of each selected pair of probe electrodes via a second switch (S2) and a second electrode of said second measuring capacitor (C2) being connected to said reference potential.

4. The method according to claim 3, wherein during said conductance measuring steps b1):

➢ said first switch (S1) is in a closed state while said alternating potential (VS) is increasing, while said alternating potential (VS) is above said constant reference potential and while said alternating potential (VS) is decreasing; and
➢ said second switch (S2) is in a closed state while said alternating potential (VS) is decreasing, while said alternating potential (VS) is below said constant reference potential and while said alternating potential (VS) is increasing.

5. The method according to claim 3 or 4, wherein during said capacitance measuring steps b2):

➢ said first switch (S1) is in a closed state while said alternating potential (VS) is increasing; and
➢ said second switch (S2) is in a closed state while said alternating potential (VS) is decreasing.

6. The method according to any one of claims 2 through 5, wherein said alternating potential (source voltage VS) is symmetrical with respect to said constant reference potential (Vref).

7. The method according claim 6, wherein said alternating potential is a square wave potential (VS).

8. The method according to claim 6 or 7, wherein during said conductance measuring steps b1):

  ➢ said first switch (S1) is closed before said alternating potential undergoes a transition from its low value to its high value and is opened again after said alternating potential wave undergoes a transition back to its low value; and
  ➢ said second switch (S2) is closed before said alternating potential undergoes a transition from its high value to its low value and is opened again after said alternating potential undergoes a transition back to its high value.

9. The method according to any one of claims 6 through 8, wherein during said capacitance measuring steps b2):

  ➢ said first switch (S1) is maintained in a closed state while said alternating potential undergoes a transition from its low value to its high value; and
  ➢ said second switch (S2) is maintained in a closed state while said alternating potential undergoes a transition from its high value to its low value.

10. The method according to any one of claims 3 through 9, wherein a voltage produced at said fed-back output of said first operational amplifier (A1) is used as a measure for the charge injected into said first capacitor (C1); and a voltage produced at said fed-back output of said second operational amplifier (A2) is used as a measure for the charge injected into said second capacitor (C2). (A1 and A2 used for the charging and discharging period of the unknown impedance, respectively)

11. The method according to any one of claims 3 through 10, wherein said impedance measuring means is operated in a conductance measurement mode during which:

  ➢ a switching sequence defined by the closing and opening of said first switch (S1) is in phase (0 degree phase shift) with said alternating potential (source voltage VS); and
  ➢ a switching sequence defined by the closing and opening of said second switch (S2) is out of phase (180 degrees phase shift) with said alternating potential (source voltage VS); and wherein the duration of the closed state of each of the first and second switches (S1, S2) is longer than the duration of the open state of each of the first and second switches (S1, S2) such that there is an overlap period when both switches (S1, S2) are simultaneously closed; and calculating the conductance G from the individual or averaged output voltage of said first and/or second operational amplifiers (A1, A2).

12. The method according to any one of claims 3 through 11, wherein said impedance measuring means is operated in a capacitance measurement mode during which:

  ➢ a switching sequence defined by the closing and opening of said first switch (S1) is out of phase (+90 degree phase shift) with said alternating potential (source voltage VS); and
  ➢ a switching sequence defined by the closing and opening of said second switch (S2) is out of phase (-90 degrees phase shift) with said alternating potential (source voltage VS); and wherein

  the duration of the closed state of each of the first and second switches (S1, S2) is longer than the duration of the open state of each of the first and second switches (S1, S2) such that there is an overlap period when both switches (S1, S2) are simultaneously closed; and calculating the capacitance C from the individual or averaged output voltage of said first and/or second operational amplifiers (A1, A2).

13. The method according to claim 11 or 12, wherein the time period TC1 of the closed state of said first switch (S1), the time period TC2 of the closed state of said second switch (S2) and the time period of the overlap period TC12 at the beginning or at the end of each time period TC1 or TC2 are related such that
0.1 < TC12/TC1 < 0.5 and 0.1 < TC12/TC2 < 0.5.

14. The method according to any one of claims 11 through 13, wherein the time period TC1 of the closed state of said first switch (S1); the time period TC2 of the closed state of said second switch (S2); the positive time period Tpos, where said alternating potential (VS) is greater than said constant reference potential (Vref); and the negative time period Tneg, where said alternating potential (VS) is less than said constant reference potential (Vref) are related such that

$1.1 < TC1 / Tpos < 1.5$ and $1.1 < TC2 / Tneg < 1.5$.

15. 15. The method according to claim 14, wherein the time period Tpos and the time period Tneg are identical: Tpos = Tneg.

16. 16. The method according to claim 14 or 15, wherein the time period TC1 and the time period TC2 are identical: TC1 = TC2.

17. The method according to any one of claims 2 through 16, wherein the constant reference potential (Vref) is the ground potential.

18. The method according to any one of claims 11 through 17, wherein said conductance measurement mode and said capacitance measurement mode are performed during a conductance measurement interval and during a capacitance measurement interval, respectively.

19. The method according to claim 18, wherein said conductance measurement mode and said capacitance measurement mode are performed alternately.

20. The method according to any one of claims 11 through 19, wherein the number of counted charging cycles and counted discharging cycles is increased for smaller measured or expected values of C or G and decreased for larger measured or expected values of C or G.

21. An apparatus for determining water content and/or density of a material, which apparatus includes the following data acquisition and data processing means:

> ➢ two or more probe electrodes (E) for positioning within or in the vicinity of said material;
> ➢ impedance measuring means (IM) connected to said probe electrodes (E), said impedance measuring means being adapted to output capacitance values C and/or conductance values G representative of a distribution of the material; and
> ➢ pattern construction means (PC) for determining a conductivity distribution pattern of the material from conductance values measured between selected pairs of said probe electrodes, and for determining a permittivity distribution pattern of the material from capacitance values measured between selected pairs of said probe electrodes;

wherein said impedance measuring means (IM) comprises:

> ➢ a first operational amplifier (A1) having a first measuring capacitor (C1) connected across its first and second inputs and having its output fed back to its first input;
> ➢ a second operational amplifier (A2) having a second measuring capacitor (C2) connected across its first and second inputs and having its output fed back to its first input;
> ➢ a first electrode of said first measuring capacitor (C1) being connectable to the second probe electrode of each selected pair of probe electrodes via a first switch (S1) and a second electrode of said first measuring capacitor (C1) being connected to said reference potential;
> ➢ a first electrode of said second measuring capacitor (C2) being connectable to the second probe electrode of each selected pair of probe electrodes via a second switch (S2) and a second electrode of said second measuring capacitor (C2) being connected to said reference potential.

22. The apparatus according to claim 21, wherein said first and second switches are electronic switches.

**Fig. 1**

**Fig. 2**

**Fig. 3**

**Fig. 4** Switching sequence for Resistance mode

**Fig. 5**. Switching sequence in Capacitance mode

**Fig. 6**. Modified circuit to reduce sensitivity

**Fig. 7**. Example of current pulse reduction technique

European Patent
Office

# EUROPEAN SEARCH REPORT

Application Number

EP 07 01 7080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 00/62100 A (PROCESS TOMOGRAPHY FORESIGHT T [GB]; DYAKOWSKI TOMASZ [GB]; YORK TREVO) 19 October 2000 (2000-10-19) * page 2, paragraph 3 * * page 4, paragraph 4 * ----- | 1,2 | INV. G01N27/02 G01R27/00 G06T11/00 |
| Y | HOYLE B S ET AL: "DESIGN AND APPLICATION OF A MULTI-MODAL PROCESS TOMOGRAPHY SYSTEM" MEASUREMENT SCIENCE AND TECHNOLOGY, IOP, BRISTOL, GB, vol. 12, no. 8, August 2001 (2001-08), pages 1157-1165, XP008040617 ISSN: 0957-0233 * paragraph [0004] * ----- | 1,2 | |
| Y | SCAIFE J M ET AL: "CONDUCTIVITY AND PERMITTIVITY IMAGES FROM AN INDUCED CURRENT ELECTRICAL IMPEDANCE TOMOGRAPHY SYSTEM" IEE PROCEEDINGS: SCIENCE, MEASUREMENT AND TECHNOLOGY, IEE, STEVENAGE, HERTS, GB, vol. 141, no. 5, 1 September 1994 (1994-09-01), pages 356-362, XP000471532 ISSN: 1350-2344 * abstract * ----- | 1,2 | |
| Y | US 2004/095154 A1 (LUNDSTROM JOHN W [US] ET AL) 20 May 2004 (2004-05-20) * paragraphs [0017] - [0020] * ----- | 1,2 | TECHNICAL FIELDS SEARCHED (IPC) G01N G01R G06T A61B |
| Y | WO 2004/074781 A (PURDUE RESEARCH FOUNDATION [US]; DRNEVICH VINCENT P [US]; YU XIONG [US) 2 September 2004 (2004-09-02) * abstract * ----- | 1,2 | |

-/--

The present search report has been drawn up for all claims

| Place of search | Date of completion of the search | Examiner |
|---|---|---|
| Munich | 16 April 2008 | Stussi, Elisa |

EPO FORM 1503 03.82 (P04C01)

**European Patent Office**

**EUROPEAN SEARCH REPORT**

Application Number

EP 07 01 7080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 0 326 266 A (UNIV MANCHESTER [GB]) 2 August 1989 (1989-08-02) * the whole document * | 1,2 | |
| A | HUANG S M ET AL: "Conductivity effects on capacitance measurements of two-component fluids using the charge transfer method" JOURNAL OF PHYSICS E. SCIENTIFIC INSTRUMENTS, INSTITUTE OF PHYSICS PUBLISHING, BRISTOL, GB, vol. 21, no. 6, 1 June 1988 (1988-06-01), pages 539-548, XP020018789 ISSN: 0022-3735 * the whole document * | 1,2 | |
| A | HUANG S M ET AL: "TOMOGRAPHIC IMAGING OF TWO-COMPONENT FLOW USING CAPACITANCE SENSORS" JOURNAL OF PHYSICS E. SCIENTIFIC INSTRUMENTS, IOP PUBLISHING, BRISTOL, GB, vol. 22, no. 3, 1 March 1989 (1989-03-01), pages 173-177, XP000209343 ISSN: 0022-3735 * the whole document * | 1,2 | **TECHNICAL FIELDS SEARCHED (IPC)** |
| A | LUCAS G P ET AL: "MEASUREMENT OF THE SOLIDS VOLUME FRACTION AND VELOCITY DISTRIBUTIONS IN SOLIDS-LIQUID FLOWS USING DUAL-PLANE ELECTRICAL RESISTANCE TOMOGRAPHY" FLOW MEASUREMENT AND INSTRUMENTATION, BUTTERWORTH-HEINEMANN, OXFORD, GB, vol. 10, no. 4, 1999, pages 249-258, XP008040707 ISSN: 0955-5986 * the whole document * | 1,2 | |

-/--

The present search report has been drawn up for all claims

| Place of search | Date of completion of the search | Examiner |
|---|---|---|
| Munich | 16 April 2008 | Stussi, Elisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................................

& : member of the same patent family, corresponding document

EPO FORM 1503 03.82 (P04C01)

**European Patent Office**

**EUROPEAN SEARCH REPORT**

Application Number

EP 07 01 7080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 284 676 A (PROCESS TOMOGRAPHY LTD [GB]) 14 June 1995 (1995-06-14) | 3,21,22 | |
| A | * pages 2-5; figure 3 * | 4-20 | |
| A | GB 2 302 408 A (PROCESS TOMOGRAPHY LTD [GB]) 15 January 1997 (1997-01-15) * the whole document * | 3-22 | |

TECHNICAL FIELDS SEARCHED (IPC)

The present search report has been drawn up for all claims

| Place of search | Date of completion of the search | Examiner |
|---|---|---|
| Munich | 16 April 2008 | Stussi, Elisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent

Office

**Application Number**

EP 07 01 7080

---

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

**European Patent Office**

**LACK OF UNITY OF INVENTION SHEET B**

The Search Division considers that the present European patent application does not comply with the requirements of unity of invention and relates to several inventions or groups of inventions, namely:

1. claims: 1,2

   Method for determining water content and/or density of a material with the following data acquisition and data processing means: two or more probe electrodes; impedance measuring means for measuring a capacitance and conductance distribution in the material; pattern construction means for determining a conductivity distribution pattern and a permittivity distribution pattern in the material; with the following steps: providing a first calibration characteristics for local conductivity values as a function of both moisture content and density; providing a second calibration characteristics for local permittivity values as a function of both moisture content and density; based on the measured conductivity and permittivity distribution patterns, and the calibration characteristics determining a moisture distribution pattern and a density distribution pattern of the material.

   ---

2. claims: 3-22

   Apparatus for determining water content and/or density of a material including the following means: two or more probe electrodes; impedance measuring means for measuring a capacitance and conductance distribution in the material; pattern construction means for determining a conductivity distribution pattern and a permittivity distribution pattern in the material; wherein said impedance measuring means comprises a first operational amplifier having a first masuring capacitor connected across its first and second inputs and having its output fed back to its first input; a second operational amplifier having a second measuring capacitor connected across its forst and second inputs and having its output fed back to its first input; a first electrode of said first measuring capacitor being connectable to the second probe electrode of each selected pair of probe electrodes via a first switch and a second electrode of said first measuring capacitor being connected to said reference potential; a first electrode of said second measuring capacitor being connectable to the second probe electrode of each selected pair of probe electrodes via a second switch and a second electrode of said second measuring capacitor being connected to said reference potential.

   ---

**ANNEX TO THE EUROPEAN SEARCH REPORT
ON EUROPEAN PATENT APPLICATION NO.**

EP 07 01 7080

This annex lists the patent family members relating to the patent documents cited in the above-mentioned European search report.
The members are as contained in the European Patent Office EDP file on
The European Patent Office is in no way liable for these particulars which are merely given for the purpose of information.

16-04-2008

| Patent document cited in search report | | | Publication date | Patent family member(s) | | | Publication date |
|---|---|---|---|---|---|---|---|
| WO | 0062100 | A | 19-10-2000 | AU | 4416500 | A | 14-11-2000 |
| | | | | GB | 2363851 | A | 09-01-2002 |
| US | 2004095154 | A1 | 20-05-2004 | NONE | | | |
| WO | 2004074781 | A | 02-09-2004 | US | 2004201385 | A1 | 14-10-2004 |
| EP | 0326266 | A | 02-08-1989 | CA | 1324410 | C | 16-11-1993 |
| | | | | DE | 68903113 | D1 | 12-11-1992 |
| | | | | DE | 68903113 | T2 | 13-05-1993 |
| | | | | GB | 2214640 | A | 06-09-1989 |
| | | | | NO | 890222 | A | 21-07-1989 |
| | | | | US | 5130661 | A | 14-07-1992 |
| GB | 2284676 | A | 14-06-1995 | NONE | | | |
| GB | 2302408 | A | 15-01-1997 | NONE | | | |

EPO FORM P0459

For more details about this annex : see Official Journal of the European Patent Office, No. 12/82